(19) **Europäisches Patentamt**

**European Patent Office**

**Office européen des brevets**

(11) **EP 0 790 690 B1**

(12) **EUROPÄISCHE PATENTSCHRIFT**

(45) Veröffentlichungstag und Bekanntmachung des Hinweises auf die Patenterteilung:
**07.07.2004   Patentblatt 2004/28**

(51) Int Cl.$^7$: **H02J 7/00**, G01R 31/36

(21) Anmeldenummer: **97101643.1**

(22) Anmeldetag: **03.02.1997**

(54) **Batteriemessmodul**

Battery measurement module

Module pour la détermination de l'état d'une batterie

(84) Benannte Vertragsstaaten:
**DE FR GB IT**

(30) Priorität: **14.02.1996   DE 19605481**

(43) Veröffentlichungstag der Anmeldung:
**20.08.1997   Patentblatt 1997/34**

(73) Patentinhaber: **Chloride SpA**
**40142 Bologna (IT)**

(72) Erfinder:
• **Lohner, Andreas, Dipl.-Ing.**
  **52072 Aachen (DE)**

• **Mauracher, Peter, Dipl.-Ing.**
  **52146 Würselen (DE)**
• **Fleisch, Karl, Dipl.-Ing. (FH)**
  **91054 Erlangen (DE)**

(74) Vertreter: **LOUIS- PÖHLAU- LOHRENTZ**
**Postfach 3055**
**90014 Nürnberg (DE)**

(56) Entgegenhaltungen:
**EP-A- 0 080 164        EP-A- 0 277 321**
**DE-A- 4 225 746        DE-C- 4 408 740**
**DE-U- 9 010 972        FR-A- 2 714 477**
**GB-A- 2 243 695**

**Beschreibung**

Die Erfindung bezieht sich auf Batteriemeßmodul zur on-line-Ermittlung von mehreren Blockspannungen einer aus mehreren Blockbatterien bestehenden Batterie.

Aus der DE 44 08 740 C1 ist eine Schaltungsanordnung zur Überprüfung der mehrzelligen Batterie etwa einer Notstromversorgung bekannt, wofür dort jeder Batteriezelle eine eigene, autark funktionstüchtige Spannungsmeßschaltung mit jeweils eigenem Mikrocontroller für individuelle Auswertung und Anzeige parallel geschaltet ist, deren Auswerteschaltungen unabhängig vom Zustand der Batterie aus einer eigenständigen Stromversorgung gespeist werden. Eine solche Anordnung ist ersichtlich apparativ sehr aufwendig, und sie verlangt für Einstellungen und Abfragen, also für die Funktionsvorgaben an die einzelnen Meßschaltungen sowie für das Management der daraus parallel anfallenden Meßdaten ein Bus-System, um den Schaltungsaufwand in der Einbauumgebung der Batterien in Grenzen zu halten.

Für die unterbrechungsfreie Stromversorgung elektrischer Geräte mit einphasigem oder dreiphasigem Netzanschluß sind im Handel USV-Geräte erhältlich. Diese Geräte versorgen den Anwender nach dem echten on-line-Funktionsprinzip absolut unterbrechungsfrei und mit konstant guter Versorgungsqualität. Diese USV-Geräte sind mit einem Batteriefach ausgestattet oder weisen einen Batterieschrank auf. USV-Geräte und Batterieschrank können nebeneinander aufgestellt werden, sie bilden dann eine geschlossene Einheit. Die Batterieschränke bestehen aus mehreren Schrankgrößen passend zum jeweiligen USV-Gerät. Die USV-Leistung und die gewünschte Überbrückungszeit bestimmen die Anzahl der benötigten Batterieschränke. Bei großen Leistungen werden mehrere einzelne Schränke nebeneinander aufgestellt.

Die USV-Batterie kann beispielsweise aus 46 Blockbatterien in Reihenschaltung bestehen. Diese sind auf beschichteten und somit isolierten Tragschienen in mehreren Ebenen angeordnet und dort fixiert. Zwischen den Blöcken dienen senkrechte Durchlüftungsflächen für eine gute Wärmeabfuhr. Die Blöcke sind mit hochstromfesten und säurefesten Verbindern verschaltet. Die Batterieanschlüsse und die Verbinder sind isoliert, so daß auch bei geöffneter Tür ein Berührungsschutz besteht. Zur elektrischen Trennung von Batterie und USV-Gerät sowie zum Schutz des Batteriestromkreises dient ein Sicherungstrenner. Im Plus- und Minuspfad sind überflinke Sicherungen eingesetzt.

Die im Handel erhältlichen USV-Geräte weisen ein Batterie-Management-System auf, mit dem die Batterie geladen und überwacht wird. Als Blockbatterien werden verschlossene Bleibatterien verwendet. Diese Batterien haben eine Nennlebensdauer von etwa fünf oder zehn Jahren, die selten erreicht wird. Da auch kurze Netzunterbrechungen große Investitionen oder sogar Menschenleben gefährden können, ist der Betreiber einer USV-Anlage darauf angewiesen, jederzeit über den genauen Zustand seiner USV informiert zu sein.

Im Falle eines Stromausfalls gibt die Stützzeit an, wie lange die Last mit Batteriebetrieb noch betrieben werden kann. Handelsübliche USV-Geräte geben die Stützzeit nur sehr ungenau an. In die Berechnung geht der aktuelle Batteriezustand nicht ein, daraus ergeben sich oft fehlerhafte Stützzeitberechnungen. Die USV-Batterie, die aus einer Vielzahl von in Serie geschalteten Blockbatterien besteht, wird heute noch häufig mit einem einfachen IU-Ladeverfahren geladen. Dies führt zu erheblichen Überspannungen an einigen Blockbatterien. Die verstärkte Gasung dieser Blockbatterien führt zu deren Austrocknung und damit zum vorzeitigen Ausfall der Blockbatterie und damit der gesamten USV-Batterie.

Nach einem Stromausfall wird die Last aus der USV-Batterie des USV-Gerätes weiterversorgt. Das USV-Gerät muß abgeschaltet werden, wenn die Batterie leer ist, um Schaden an der Batterie zu vermeiden. Die Abschaltschwelle ist bei handelsüblichen Geräten ein Spannungswert, den die Gesamtspannung der USV-Batterie nicht unterschreiten darf. Dieses Entladeschlußkriterium führt dazu, daß einige Blockbatterien tief entladen werden. Auch diese Schädigung führt zu einem vorzeitigen Ausfall der gesamten USV-Batterie.

Handelsübliche USV-Geräte erkennen den Ausfall einer Blockbatterie oft erst bei einem Netzausfall. Da dies natürlich nicht akzeptabel ist, werden kritische Lasten oft durch zwei unabhängige USVs mit zwei unabhängigen Batterien gesichert.

Es ist also dringend erforderlich, solche defekten Module schon frühzeitig zu erkennen.

Tritt ein Servicefall ein, so ist die Dauer der Fehlersuche bei handelsüblichen USV-Geräten ein wesentlicher Kostenfaktor. Bei handelsüblichen USV-Geräten kann das Batterie-Management-System weder den Fehler innerhalb der USV-Batterie lokalisieren noch die Ursache (Batterie defekt, Polverbinder fehlerhaft, Trennschalter ...) angeben.

Vorgeschädigte Blockbatterien, die vom Batteriehersteller geliefert werden, werden oft nicht erkannt und trotzdem in Batterieschränke eingebaut. So sind Ausfälle bei Kunden vorprogrammiert, die den Serviceaufwand erhöhen.

Diese aufgezeigten Nachteile bei handelsüblichen USV-Geräten beruhen darauf, daß entweder nur die Gesamtspannung oder die Spannungen an einer Mittenanzapfung der USV-Batterie erfaßt und ausgewertet werden. Die Informationen, die auf diesem Weg gewonnen werden, reichen nicht aus, um den Zustand der aus mehreren Blockbatterien bestehenden USV-Batterie beurteilen zu können. Das ist der hauptsächliche Grund für den vorzeitigen Ausfall der USV-Batterie.

Der Erfindung liegt nun die Aufgabe zugrunde, eine Einrichtung anzugeben, mit der eine ausreichende Information über die USV-Batterie zur Verfügung steht, so daß die genannten Nachteile vermieden werden können. Dabei soll der technische Aufwand möglichst gering bleiben.

Diese Aufgabe wird erfindungsgemäß dadurch gelöst, daß mittels eines oder mehrerer Batteriemeßmodule, dessen Merkmale im Anspruch 1 angegeben sind, die Blockspannungen der einzelnen Blockbatterien der USV-Batterie ermittelt werden können und für eine digitale Datenübertragung zu einem Batterie-Management-System aufbereitet werden. Durch die Verwendung des erfindungsgemäßen Batteriemeßmoduls erhält das im USV-Gerät vorhandene Batterie-Management-System laufend ausreichend Information über die kleinste Einheit, nämlich die Blockbatterie, der USV-Batterie, so daß eine Veränderung in der USV-Batterie nicht nur erkannt, sondern auch lokalisiert werden kann.

Somit kann der Serviceaufwand reduziert werden, die einzelnen Blockbatterien können vor Tiefentladung und Überspannung geschützt werden und die Blockbatterien einer USV-Batterie vor Auslieferung getestet werden, so daß defekte Batterien beim USV-Hersteller noch erkannt und ausgetauscht werden können.

Bei einer vorteilhaften Ausgestaltung des Batteriemeßmoduls ist seine Steuer- und Verarbeitungseinrichtung mit einem Dateneingang und -ausgang versehen, an dem eine Datenübertragungsleitung anschließbar ist. Dadurch besteht die Möglichkeit, mehrere Batteriemeßmodule sequentiell anordnen zu können. Dies ist erforderlich, wenn eine USV-Batterie beispielsweise aus mehreren als das Vielfache von acht bis zehn Blockbatterien besteht. Dadurch, daß mittels eines Batteriemeßmoduls eine vorbestimmte Anzahl von Blockspannungen ermittelt werden kann, besteht durch die sequentielle Anordnung mehrerer Batteriemeßmodule die Möglichkeit, die Blockspannungen und somit die Gesamtspannung von einphasigen und dreiphasigen online-USV-Geräten über einen weiten Leistungsbereich zu ermitteln, ohne dabei den Verkabelungsaufwand innerhalb der USV-Batterie zu erhöhen.

Bei einer weiteren vorteilhaften Ausführungsform des erfindungsgemäßen Batteriemeßmoduls ist seine Stromversorgung abschaltbar. Da der Versorgungsstrom des Batteriemeßmoduls direkt aus den Blockbatterien der USV-Batterie entnommen wird, könnte während der Ruhepausen des bzw. der Batteriemeßmoduls bzw. -module die USV-Batterie über einen gewissen Zeitbereich entladen werden. Durch die Abschaltbarkeit der Stromversorgung des bzw. der Batteriemeßmoduls bzw. -module in den Ruhepausen wird die Entladung der USV-Batterie verhindert. Im ausgeschalteten Zustand liegt der Stromverbrauch des Batteriemeßmoduls deutlich unter der Selbstentladung der Blockbatterien der USV-Batterie.

In den Unteransprüchen 4 bis 9 sind die Ausgestaltungen der Komponenten des erfindungsgemäßen Batteriemeßmoduls näher angegeben.

Zur weiteren Erläuterung der Erfindung wird auf die Bezeichnung Bezug genommen, in der eine Ausführungsform eines Batteriemeßmoduls gemäß der Erfindung schematisch veranschaulicht ist.

Figur 1 zeigt ein Blockschaltbild eines Batteriemeßmoduls gemäß der Erfindung, die

Figur 2 zeigt das elektrische Ersatzschaltbild eines Meßkanals des Batteriemeßmoduls gemäß Figur 1 und die

Figur 3 veranschaulicht in einem Diagramm über der Zeit t die Signalverläufe des Meßkanals nach Figur 2.

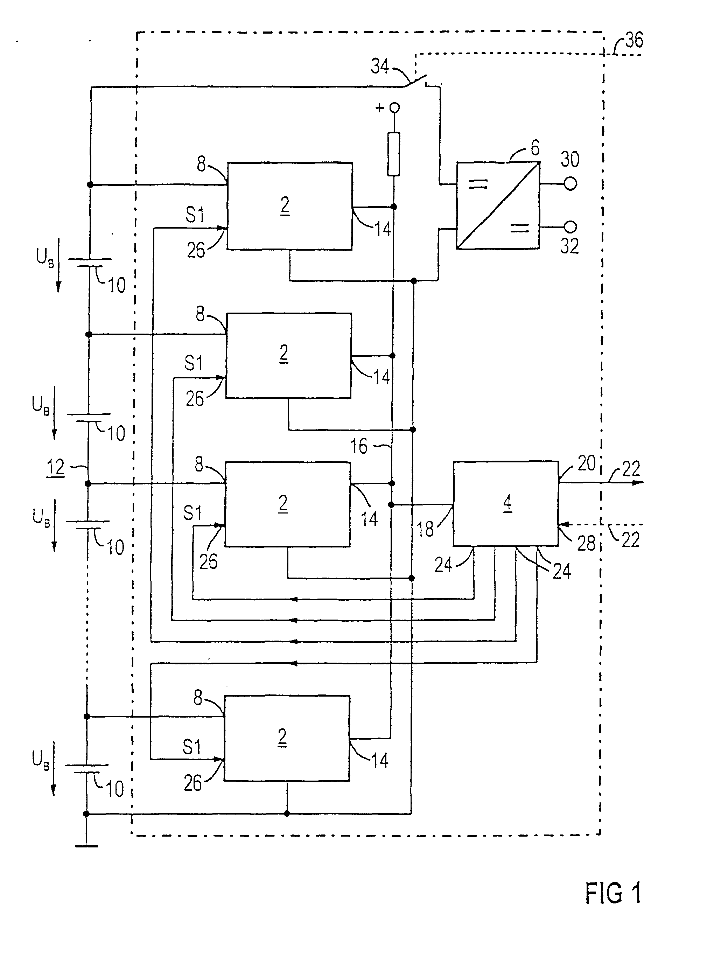

In der Figur 1 ist ein Blockschaltbild eines Batteriemeßmoduls gemäß der Erfindung veranschaulicht. Dieses Batteriemeßmodul weist mehrere, beispielsweise acht Meßkanäle 2, eine Steuer- und Verarbeitungseinrichtung 4 und eine Stromversorgung 6 auf. Der Eingang 8 jedes Meßkanals 2 ist mit einem Pluspol einer Blockbatterie 10 einer USV-Batterie 12 elektrisch leitend verbunden. Die Ausgänge 14 der Meßkanäle 2 des Batteriemeßmoduls sind miteinander zu einem Meßwert-Ausgang 16 verbunden. Dieser Meßwert-Ausgang 16 ist mit einem Meßwert-Eingang 18 der Steuer- und Verarbeitungseinrichtung 4 verknüpft. Als Steuer- und Verarbeitungseinrichtung 4 ist ein Mikrocontroller vorgesehen. Am Daten-Ausgang 20 dieses Mikrocontrollers 4 ist eine Datenübertragungsleitung 22 angeschlossen, die mit einem nicht näher dargestellten Batterie-Management-System verbunden ist. Als Datenübertragungsleitung 22 ist ein Lichtwellenleiter vorgesehen. Durch die Wahl des Lichtwellenleiters als Datenübertragungsleitung 22 wird sowohl eine Potentialtrennung zwischen Batteriemeßmodul und Batterie-Management-System als auch eine hohe Störsicherheit der Datenübertragung erreicht. Lichtwellenleiter sind in diesem Anwendungfall kostengünstiger als eine konventionelle Datenübertragung. Aufgrund der hohen Spannungen in einem USV-Batterieschrank wäre die Verkabelung mit Kupferleitungen extrem aufwendig.

Die Steuer- und Verarbeitungseinrichtung 4 weist mehrere Steuerausgänge 24 auf, die jeweils mit einem Steuereingang 26 der Meßkanäle 2 elektrisch leitend verbunden sind. Die Steuer- und Verarbeitungseinrichtung 4 weist ebenfalls einen Daten-Eingang 28 auf, an dem eine weitere Datenübertragungsleitung 22 angeschlossen werden kann. Aus diesem Grund ist diese weitere Datenübertragungsleitung 22 mittels einer unterbrochenen Linie dargestellt. Diese weitere Datenübertragungsleitung 22 wird benötigt, wenn mehrere Batteriemeßmodule sequentiell angeordnet werden. Dabei wird beispielsweise der Daten-Ausgang 20 eines ersten Batteriemeßmoduls mittels der weiteren Datenübertragungsleitung 22 mit einem Daten-Eingang 28 eines nächsten Batteriemeßmoduls verbunden, das wiederum mittels einer Datenübertragungsleitung 22 seinen Daten-Ausgang 20 mit einem Daten-Eingang 28 des nächsten Batteriemeßmoduls verbindet.

Die Anzahl der verwendeten Batteriemeßmodule bei einer USV-Batterie 12 hängt von der Spannungsfestigkeit der Meßkanäle 2 und von der Meßwert-Auflösung ab. Bei einer USV-Batterie 12, die beispielsweise 276 Zellen mit jeweils einer Zellenspannung von 2,4 V hat, von denen jeweils sechs Zellen eine Blockbatterie 10 darstellen, besteht diese USV-Batterie 12 aus 46 Blockbatterien 10 mit jeweils einer Blockspannung von 14,4 V und damit einer Gesamtspannung 662,4 V. Bei einer derartigen USV-Batterie 12 könnte man mit sechs Batteriemeßmoduln mit jeweils acht Meßkanälen 2 jede Blockspannung $U_B$ der USV-Batterie 12 ermitteln.

Durch die sequentielle Anordnung von mehreren Batteriemeßmoduln wird der Verkabelungsaufwand innerhalb der USV-Batterie 12 gering gehalten, da mit einem Batteriemeßmodul nur benachbarte Blockbatterien 10 verbunden werden. Außerdem verringert sich die maximale Eingangsspannung eines Batteriemeßmoduls, was die Anforderung an die Spannungsfestigkeit der Meßtechnik reduziert. Durch das modulare Konzept ist das Batteriemeßmodul sowohl für den Einsatz in mehrsträngigen USV-Anlagen als auch in USV-Anlagen für andere Netzspannungsebene geeignet.

Die Spannungsversorgung der Meßkanäle 2 und der Steuer- und Verarbeitungseinrichtung 4 erfolgt mittels der Stromversorgung 6, die hier zwei Ausgänge 30 und 32 aufweist. Am Ausgang 30 steht eine Spannung von +15 V für die Meßkanäle 2 und am Ausgang 32 eine Spannung von +5 V für die Steuer- und Verarbeitungseinrichtung 4 an. In dieser vorteilhaften Ausführungsform des Batteriemeßmoduls ist die Stromversorgung über einen Schalter 34 mit einem Pluspol der ersten Blockbatterie 10 - höchste auftretende Spannung für das Batteriemeßmodul - verbunden. Der Schalter 34 wird von einem nicht näher dargestellten Batterie-Management-System betätigt. Dies ist durch die unterbrochene Wirklinie 36 dargestellt. In den Ruhepausen des Batteriemeßmoduls wird die Stromversorgung 6 abgeschaltet. Im ausgeschalteten Zustand liegt der Stromverbrauch des Batteriemeßmoduls deutlich unter der Selbstentladung der Blockbatterien 10 der USV-Batterien 12.

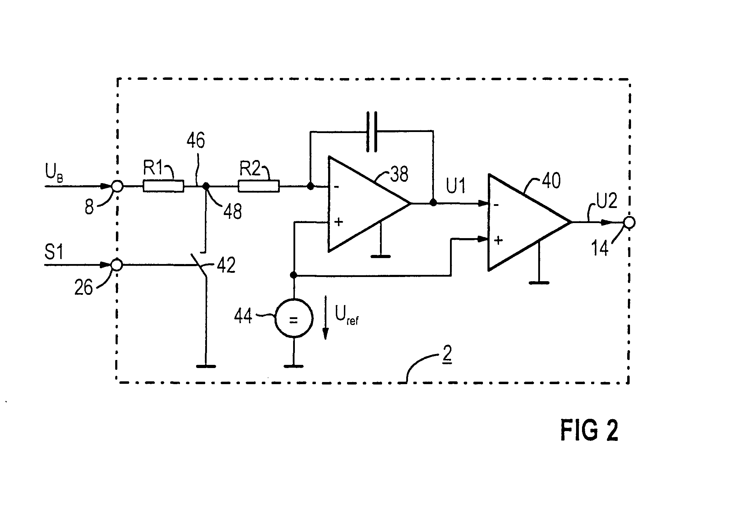

Die Figur 2 zeigt das elektrische Ersatzschaltbild eines Meßkanals 2 des Batteriemeßmoduls nach Figur 1. Als Meßkanal 2 ist ein modifizierter Analogteil eines A/D-Umsetzers nach dem Dual-Slope-Verfahren vorgesehen. Die A/D-Umsetzer nach dem Dual-Slope-Verfahren besitzen die größte Bedeutung bei der A/D-Umsetzung nach dem Zählverfahren, weil·sich dabei mit geringem Aufwand die größte Genauigkeit erreichen läßt. Allerdings ist die Umsetzdauer wesentlich größer als bei anderen Verfahren zur A/D-Umsetzung. Die Umsetzdauer liegt in der Regel zwischen 1 ms und 1 s. Ein A/D-Umsetzer nach dem Dual-Slope-Verfahren ist beispielsweise aus dem Buch von U. Tietze und Ch.

Schenk mit dem Titel "Halbleiter-Schaltungstechnik", 1983, Seiten 774-777, bekannt.

Gegenüber diesem bekannten A/D-Umsetzer nach dem Dual-Slope-Verfahren ist der A/D-Umsetzer beim erfindungsgemäßen Batteriemeßmodul in einen Analogteil und einen Digitalteil unterteilt, wobei der Analogteil jeweils durch einen Meßkanal 2 und die Digitalteile aller Meßkanäle durch die Steuer- und Verarbeitungseinrichtung 4 realisiert werden. Diese Steuer und Verarbeitungseinrichtung 4 führt die eigentliche A/D-Umsetzung und Filterung der Meßwerte durch. Da diese digitalen Meßwerte in dem übergeordneten Batterie-Management-System mittels eines Rechners weiterverarbeitet werden, kann zur Entlastung des Batterie-Management-Systems der Mikrocontroller 4 des Batteriemeßmoduls Aufgaben vom Batterie-Management-System übernehmen.

Der modifizierte Analogteil weist einen Integrator 38, einen Komparator 40, einen Schalter 42, eine Referenzspannungsquelle 44 und eine Reihenschaltung 46 zweier Widerstände R1 und R2 auf. Die Reihenschaltung 46 ist eingangsseitig mit dem Eingang 8 des Meßkanals 2 und ausgangsseitig mit dem invertierenden Eingang des Integrators 38 verknüpft. Der Ausgang dieses Integrators 38 ist mit dem invertierenden Eingang des Komparators 40 verbunden, dessen Ausgang mit dem Ausgang 14 des Meßkanals 2 verknüpft ist. Die Referenzspannungsquelle 44 ist mit seinem positiven Pol mit dem nichtinvertierenden Eingang des Integrators 38 und des Komparators 40 elektrisch leitend verbunden. Der negative Pol dieser Referenzspannungsquelle 44 ist ebenso wie der Integrator 38 und der Komparator 40 mit dem Bezugspotential des Batteriemeßmoduls verknüpft. Der Schalter 42 ist zwischen einem Mittenanschluß 48 der Reihenschaltung 46 und dem Bezugspotential des Batteriemeßmoduls geschaltet. Der Betätigungseingang des Schalters 42 ist mit dem Steuereingang 26 des Meßkanals 2 verbunden. Als Schalter 42 kann ein Halbleiterschalter, beispielsweise ein Feldeffekttransistor, vorgesehen sein. Der Vorteil von Feldeffekttransistoren liegt im Gegensatz zu bipolaren Transistoren darin, daß mit einem elektrischen Feld, d.h. leistungslos, gesteuert wird.

Da das in Figur 1 dargestellte Batteriemeßmodul mehrere Meßkanäle 2, beispielsweise acht, die gemeinsam mit einer Steuer- und Verarbeitungseinrichtung 4 verbunden sind, ist eine ODER-Verknüpfung erforderlich. Diese ODER-Verknüpfung der Ausgänge 14 der Meßkanäle 2 wird mit einer Wired-OR-Verbindung realisiert. Dazu werden Komparatoren 40 mit offenem Kollektor-Ausgang (Open Collector) verwendet. Diese Komparatoren 40 besitzen als Ausgangsstufe lediglich einen npn-Transistor, dessen Emitter an Masse liegt. Solche Ausgänge kann man ohne weiteres parallel schalten und mit einem gemeinsamen Kollektorwiderstand versehen.

Als Referenzspannungsquelle 44 wird eine Spannungsquelle mit einem Referenzspannungswert Uref gewählt, der kleiner ist als der Spannungswert $U_B$ einer Blockbatterie 10. Das heißt, die Referenzspannung Uref ist kleiner als ca. 8 V.

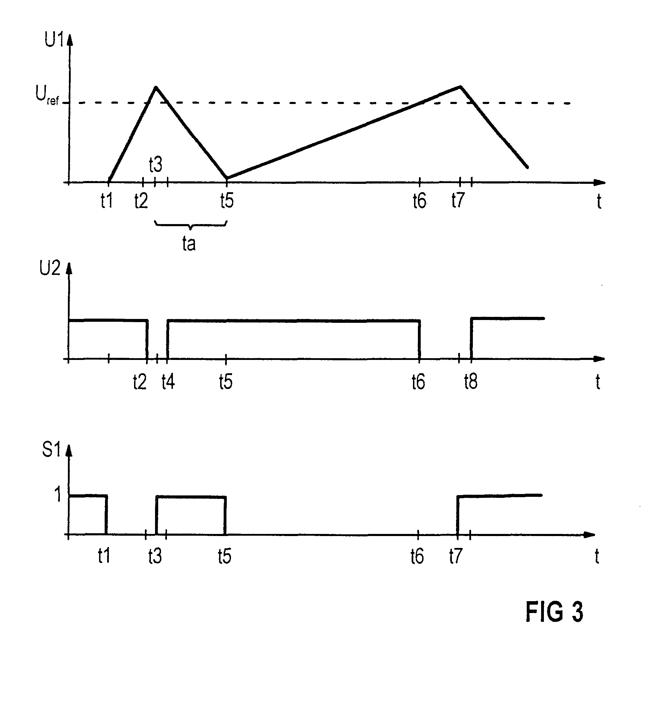

Anhand der Signalverläufe der Figur 3 wird die Funktionsweise des Meßkanals 2 im folgenden näher erläutert.

In der Figur 3 sind die Verläufe der Integrator-Ausgangsspannung U1, der Komparator-Ausgangsspannung U2 und das Steuersignal S1 des Schalters 42 jeweils in einem Diagramm über der Zeit t dargestellt. Zum Zeitpunkt t=0 ist das Steuersignal S1 "high", d.h., der Schalter 42 ist offen und am Eingang des Meßkanals 2 steht eine Blockspannung $U_B$ an. Dadurch ist die Integrator-Ausgangsspannung U1 Null und die Komparator-Ausgangsspannung U2 gleich der Versorgungsspannung des Komparators 40. Zum Zeitpunkt t=t1 wechselt das Steuersignal S1 von "high" nach "low", d. h., der Schalter 42 wird geschlossen. Dadurch ist der Signaleingang des Integrators 38 mit dem negativen Anschluß der Referenzquelle verbunden und die Integrator-Ausgangsspannung U1 steigt an. Sobald die Integrator-Ausgangsspannung U1 gleich der Referenzspannung Uref ist (Zeitpunkt t=t2), sind die Spannungen an den Eingängen des Komparators 40 gleich und die Komparator-Ausgangsspannung U2 springt auf Null. Dadurch setzt die Steuer- und Verarbeitungseinrichtung 4 das Steuersignal S1 zum Zeitpunkt t=t3 wieder auf Highpegel, d.h., der Schalter 42 wird wieder geöffnet. Dadurch steht am Signaleingang des Integrators 38 die Blockspannung $U_B$ an und die Integrator-Ausgangsspannung U1 fällt mit einer Steigung proportional der Blockspannung $U_B$. Der Schalter 42 bleibt für eine vom Mikrocontroller 4 fest vorbestimmte Zeit ta geöffnet. Zum Zeitpunkt t=t4 ist die Integrator-Ausgangsspannung U1 gleich der Referenzspannung $U_{ref}$, wodurch die Komparator-Ausgangsspannung U2 wieder auf den Wert seiner Versorgungsspannung springt. Nach Ablauf dieser vorgegebenen Zeit ta wechselt das Steuersignal S1 wieder von "high" auf "low" (t=t5), so daß der Signaleingang des Integrators 38 mit dem negativen Anschluß der Referenzquelle verbunden ist. Dadurch steigt die Integrator-Ausgangsspannung U1 wieder an. Dieser Anstieg weist eine für die Referenzspannung Uref proportionale Steigung auf. Die Zeitspanne ta wird so vom Mikrocontroller 4 vorgegeben, daß die Integrator-Ausgangsspannung U1 nicht Null wird. Zum Zeitpunkt t=t5 ist diese vorgegebene Meßzeitspanne ta abgelaufen. Zum Zeitpunkt t=t6 ist die Integrator-Ausgangsspannung U1 gleich der Referenzspannung Uref, so daß die Komparator-Ausgangsspannung U2 wieder auf Null springt. Durch den Wechsel der Komparator-Ausgangsspannung U2 wird die Zeiterfassung im Mikrocontroller 4 gestoppt und mit Hilfe der fest vorgegebenen Zeit ta, der ermittelten Zeitspanne t6-t5, der konstanten Referenzspannung Uref, Widerstände R1, R2 und der folgenden Gleichung:

$$U_B = Uref \left( 1 + \frac{R1 + R2}{R} \cdot \frac{t6 - t5}{t5} \right)$$

der Mittelwert der am Eingang 8 des Meßkanals 2 anstehenden Blockspannung $U_B$ berechnet. Bis zum Zeitpunkt t=t7 steigt die Integrator-Ausgangsspannung U1 noch an. Zu diesem Zeitpunkt t=t7 wird der Schalter 42 wieder geöffnet, wodurch die Integrator-Ausgangsspannung U1 wieder sinkt. Sobald die Integrator-Ausgangsspannung U1 gleich der Referenzspannung Uref ist, springt die Komparator-Ausgangsspannung U2 wieder auf das Potential seiner Versorgungsspannung (t=t8). Damit ist der Meßkanal 2 vom Meßwert-Ausgang 16 abgetrennt. In der Zeitspanne t6-t8, in der die Komparator-Ausgangsspannung U2 Null ist, wird der Mittelwert der anstehenden Blockspannung $U_B$ berechnet und zum Batterie-Management-System, wie der Datenübertragungsleitung 22, übertragen. Außerdem wird ein nächster Meßkanal 2 des Batteriemeßmoduls aktiviert.

Durch dieses modifizierte Dual-Slope-Meßverfahren lassen sich bei niedrigen Bauteilpreisen hohe Meßgenauigkeiten erreichen. Insbesondere für hohe Meßspannungen ist das Verfahren gut geeignet, da es ohne teuren Spannungsteiler auskommt. Die Meßwerte werden digital über Lichtwellenleiter 22 übertragen. Durch die Wahl von Lichtwellenleitern als Übertragungsstrecke wird sowohl eine Potentialtrennung der einzelnen Batteriemeßmodule als auch eine hohe Störsicherheit der Datenübertragung erreicht. Aufgrund der hohen Spannungen in USV-Batterieschränken wäre die Verkabelung mit Kupferleitungen extrem aufwendig.

Wieviele Meßkanäle 2 ein Batteriemeßmodul aufweist, hängt von der geforderten Meßwertauflösung und von der Spannungsfestigkeit der Meßtechnik ab. Bei acht Meßkanälen 2 und einer Blockspannung von 14,4 V liegt am Eingang des achten Meßkanals 2 ein Spannungswert von 115,2 V an. Das heißt, bei einer USV-Batterie 12 mit 46 Blockbatterien benötigt man sechs Batteriemeßmodule. Mit diesen sechs Batteriemeßmodulen kann man dann alle 46 Blockspannungen der USV-Batterie 12 ermitteln. Durch das modulare Konzept ist das Batteriemeßmodul sowohl für den Einsatz in mehrsträngigen USV-Anlagen als auch in USV-Anlagen für andere Netzspannungsebenen geeignet.

Da mittels mehrerer Batteriemeßmodule alle Blockspannungen $U_B$ einer USV-Batterie zur Verfügung stehen, kann die Arbeitsweise des Batterie-Management-Systems wesentlich verbessert werden. Durch die Messung der einzelnen Blockspannungen erfolgt eine genaue Fehlerlokalisierung, was die Wartungskosten der USV-Anlage reduziert. Batterie-Management geht aber über die reine Überwachung hinaus. So ergreift das Batterie-Management-System zusätzlich gezielte Maßnahmen zur Erhöhung der entnehmbaren Ladung, zur Steigerung der Betriebsdauer der Batterie und zur Vergrößerung der Wartungsintervalle der Anlage. Dies führt zu einer starken Verringerung der Betriebskosten. Zu diesen Maßnahmen zählen das temperatur- und blockspannungsgeführte schonende Laden, das Konditionieren sowie das Aussetzen der Erhaltungsladung.

Tiefentladeschutz

Bei herkömmlichen USV-Anlagen ist das Entladeschlußkriterium als das Unterschreiten eines bestimmten Gesamtspannungsniveaus definiert. Dieses Entladeschlußkriterium führt dazu, daß Batterieblöcke mit geringerer Ladung tiefentladen und somit irreparabel geschädigt werden. Diese Schädigung einzelner Blöcke führt langfristig zum Ausfall der gesamten USV-Batterie 12. Das Batterie-Management-System kann, da nun alle Blockspannungen ermittelbar sind, die Entladung vor dem Tiefentladen einzelner Blöcke abbrechen und somit eine Schädigung der Batterie durch Tiefentladung weitgehend verhindern. Nur mit Hilfe der Messung aller Blockspannungen kann das Batterie-Management-System Aussagen zum Zustand der Batterie machen.

Batterietest

Handelsübliche USV-Anlagen erkennen den Ausfall einer Blockbatterie und damit der Gesamtanlage erst bei einem Netzausfall, da sie beispielsweise die Batterielebensdauer nur temperaturabhängig schätzen. Außerdem wurden vorgeschädigte Blockbatterien oft unerkannt in Batterieschränke eingebaut. So waren Ausfälle beim Kunden vorprogrammiert.

Bei einem Batteriekreistest durch das Batterie-Management-System werden automatisch Fehler im Batteriesystem festgestellt und lokalisiert. Durch eine gezielte Teilentladung mit einem konstanten Strom und die Messung aller Blockspannungen können Fehler wie die Erhöhung des inneren Widerstandes einzelner Blockbatterien sowie schlechte Polverbinder oder offene Batterieschalter sowohl detektiert als auch lokalisiert werden. Die Werte für die inneren Widerstände der Blockbatterien werden in einem Permanentspeicher protokolliert. Weiterhin beobachtet das Batterie-Management-System die alterungsbedingte Abnahme der entnehmbaren Ladung mit Hilfe des Verlaufs der Blockspannung während der Teilentladung. Aufgrund der Entwicklung dieses Wertes kann dem Bediener die Durchführung einer Konditionierung zum Ausgleich reversibler Alterungserscheinungen empfohlen werden. Auch vorgeschädigte Batterieblöcke werden durch Messung von Innenwiderstand und entnehmbarer Ladung bereits bei der Inbetriebnahme erkannt.

Ladeverfahren

In herkömmlichen USV-Anlagen wird nach dem gesamtspannungsbegrenzten IU-Ladeverfahren geladen. Zum Ausgleich der Selbstentladung wird der USV-Batterie 12 nach dem Erreichen des Volladezustands zusätzlich ein Ladungserhaltungsstrom zugeführt. Die durch diesen Strom verursachte Gasbildung verhindert bei offenen Zellen die Säureschichtung. Um den Wartungsaufwand einer USV zu verringern, werden in letzter Zeit vermehrt geschlossene und verschlossene Batterien eingesetzt. Bei diesen Batterien führt das herkömmliche Ladeverfahren zu einer Reduktion der Lebensdauer. Durch die Gasbildung geht bei Überdruckventilöffnung unwiederbringbar Wasser verloren und die Zellen werden langfristig durch Austrocknung zerstört. Um die mögliche Lebensdauer verschlossener Batterien voll auszuschöpfen, ist ein batterieschonendes Ladeverfahren erforderlich.

Da mittels der Batteriemeßmodule alle Blockspannungen zur Verfügung stehen, kann ein blockspannungsgeführtes Laden in das Batterie-Management-System implementiert werden. Mit Hilfe dieses blockspannungsgeführten Ladens übersteigt keine Blockspannung die Ladeschlußspannung. Somit gast kein Block übermäßig. Damit ist es möglich, daß während eines Ladevorgangs die Batteriespannung so begrenzt wird, daß an keinem Batterieblock die maximale Spannung überschritten wird.

Durch den Einsatz des erfindungsgemäßen Batteriemeßmoduls in Verbindung mit dem Batterie-Management-System kann die Zuverlässigkeit und die Sicherheit der USV-Batterie 12 und damit der USV-Anlage deutlich erhöht und gleichzeitig die Betriebsund Wartungskosten reduziert werden. Zur hochgenauen Messung aller Blockspannungen steht ein preisgünstiges Batteriemeßmodul nun zur Verfügung. Dadurch können Fehler im Batteriekreis rechtzeitig erkannt und durch automatische Lokalisation kostengünstig behoben werden. Dem Bediener werden bei Bedarf Zustands- und Wartungsmeldungen des Batterie-Management-Systems angezeigt. Außerdem kann durch ein batterieschonendes, blockspannungsgeführtes Ladeverfahren mit selbstgeregeltem Nachladen anstelle dauernder Ladungserhaltung die Lebensdauer der USV-Batterie 12 deutlich erhöht werden. Ferner verhindert eine kontinuierliche Blockspannungsüberwachung das Tiefentladen einzelner Blockbatterien und reduziert die durch Tiefentladen bedingte Alterung auf ein Minimum. Weiterhin ist durch eine gezielt durchgeführte Konditionierung zusätzlich die durch Ruhestromentladungen verursachte, reversible Alterung der USV-Batterie 12 in Abhängigkeit der ermittelten Blockspannungen umkehrbar. Somit bleibt die Nennstützzeit der Anlage über einen längeren Zeitraum erhalten.

Die Gesamtheit dieser getroffenen Maßnahmen führt zu einem deutlich sicheren und zuverlässigen Betrieb der USV-Anlage.

**Patentansprüche**

1. Batteriemeßmodul zur on-line-Ermittlung von mehreren Blockspannungen ($U_B$) einer Batterie (12), die aus einer Reihenschaltung von mehreren Blocksbatterien (10-10-10) mit jeweils mehreren Zellen besteht, wobei dieses Meßmodul mehrere Meßkanäle (2) aufweist, deren Eingänge (8) an die Pluspole der einzelnen Blockbatterien (10) geschaltet sind und deren Ausgänge (14) über eine ODER-Verknüpfung zu einem gemeinsamen Meßwert-Ausgang (16) zusammengeschaltet sind, der auf den Meßwert-Eingang (18) einer den Meßkanälen (2) gemeinsamen Steuer- und Verarbeitungseinrichtung (4) geführt ist, die den Digitalteil eines A/D-Umsetzers realisiert, deren Analogteil der über einen Steuereingang (26) gerade aktivierte Meßkanal (2) ist, und die Steuerausgänge (24) zu den Steuereingängen (26) der Meßkanäle (2) sowie einen Datenausgang (20) zu einer an ein Batterie-Management-System führenden Datenübertragungsleitung (22) aufweist, mit Versorgung einerseits der Meßkanäle (2) und andererseits der Steuer- und Verarbeitungsschaltung (4) aus einer Stromversorgung (6), die ihrerseits aus der Batterie (12) gespeist ist.

2. Batteriemeßmodul nach Anspruch 1, wobei die Steuer- und Verarbeitungseinrichtung (4) mit einem Daten-Eingang (28) versehen ist, an dem eine Datenübertragungsleitung (22) anschließbar ist.

3. Batteriemeßmodul nach Anspruch 1, wobei die Stromversorgung (6) abschaltbar ist.

4. Batteriemeßmodul nach Anspruch 1, wobei als Steuer- und Verarbeitungseinrichtung (4) ein Mikrocontroller vorgesehen ist.

5. Batteriemeßmodul nach Anspruch 1, wobei jeweils als Meßkanal (2) ein modifizierter Analogteil eines A/D-Umsetzers nach dem Dual-Slope-Verfahren vorgesehen ist.

6. Batteriemeßmodul nach Anspruch 1, wobei als Datenübertragungsleitung (22) ein Lichtwellenleiter vorgesehen ist.

7. Batteriemeßmodul nach Anspruch 5, wobei der modifizierte Analogteil einen Integrator (38), einen Komparator (40), einen Schalter (42), eine Referenzspannungsquelle (44) und eine Reihenschaltung (46) zweier Widerstände (R1, R2) aufweist, wobei die Reihenschaltung (46) eingangsseitig mit dem Eingang (8) des Meßkanals (2) und ausgangsseitig mit dem invertierenden Eingang des Integrators (38) verknüpft ist, dessen Ausgang mit dem invertierenden Eingang des Komparators (40) verbunden ist, wobei der positive Pol der Referenzspannungsquelle (44) mit den nichtinvertierenden Eingängen des Integrators (38) und des Komparators (40) und sein negativer Pol mit dem Bezugspotential des Batteriemeßmoduls verknüpft ist und wobei der Schalter (42) zwischen einem Mittenanschluß (48) der Reihenschaltung (46) und dem Bezugspotential des Batteriemeßmoduls geschaltet ist und dessen Betätigungseinrichtung mit dem Steuereingang (26) des Meßkanals (2) verbunden ist.

8. Batteriemeßmodul nach Anspruch 7, wobei als Komparator (40) ein Komparator mit offenem Kollektor-Ausgang vorgesehen ist.

9. Batteriemeßmodul nach Anspruch 6, wobei als Referenzspannungsquelle (44) eine Spannungsquelle mit einem Referenzspannungswert vorgesehen ist, der kleiner als der zu messende Blockspannungswert ist.

**Claims**

1. Battery measurement module for on-line determination of two or more block voltages ($U_B$) of a battery (12) which comprises two or more block batteries (10-10-10) which are connected in series and each have two or more cells, with this measurement module having two or more measurement channels (2) whose inputs (8) are connected to the positive poles of the individual block batteries (10), and whose outputs (14) are connected together via an OR logic operation to form a common measured value output (16), which is passed to the measured value input (18) of a control and processing device (4) which is shared by the measurement channels (2) and represents the digital part of an A/D converter whose analogue part is the measurement channel (2) that is currently activated via a control input (26), and has the control outputs (24) to the control inputs (26) of the measurement channels (2) as well as a data output (20) to a data transmission line (22) which leads to a battery management system, with the measurement channels (2) on the one hand and the control and processing circuit (4) on the other hand being supplied from a power supply (6) which is itself fed from the battery (12).

2. Battery measurement module according to Claim 1, with the control and processing device (4) being provided with a data input (28) to which a data transmission line (22) can be connected.

3. Battery measurement module according to Claim 1, in which the power supply (6) can be switched off.

4. Battery measurement module according to Claim 1, with a micro controller being provided as the control and processing device (4).

**5.** Battery measurement module according to Claim 1, with a modified analogue part of an A/D converter based on the dual-slope method in each case being provided as the measurement channel (2).

**6.** Battery measurement module according to Claim 1, with an optical waveguide being provided as the data transmission line (22).

**7.** Battery measurement module according to Claim 5, with the modified analogue part having an integrator (38), a comparator (40), a switch (42), a reference voltage source (44) and a series circuit (46) formed by two resistors (R1, R2), with the series circuit (46) being linked on the input side to the input (8) of the measurement channel (2), and being linked on the output side to the inverting input of the integrator (38), whose output is connected to the inverting input of the comparator (40), with the positive pole of the reference voltage source (44) being linked to the noninverting inputs of the integrator (38) and of the comparator (40), and its negative pole being linked to the reference earth potential of the battery measurement module, and with the switch (42) being connected between a centre connection (48) of the series circuit (46) and the reference earth potential of the battery measurement module, and its operating device being connected to the control input (26) of the measurement channel (2).

**8.** Battery measurement module according to Claim 7, with a comparator with an open collector output being provided as the comparator (40).

**9.** Battery measurement module according to Claim 6, with a voltage source with a reference voltage value which is less than the block voltage value to be measured being provided as the reference voltage source (44).

## Revendications

**1.** Module de mesure à batterie pour la recherche on-line de plusieurs tensions de blocage ($U_B$) d'une batterie (12), se composant d'un branchement en série de plusieurs batteries de blocage (10, 10, 10) comportant chacune plusieurs cellules, ledit module de mesure présentant plusieurs canaux de mesure (2) dont les entrées (8) sont branchées sur le pôle « Plus » des batteries de blocage individuelles (10) et dont les sorties (14) sont branchées ensemble par une liaison « OU » à une sortie (16) à valeur de mesure commune qui est envoyée par l'entrée (18) à valeur de mesure à l'un des canaux de mesure (2) d'un système commun (4) de pilotage et de traitement, qui constitue la portion digitale d'une transformation A/D dont la portion analogique est constituée par le canal de mesure (2) activé directement par l'intermédiaire d'une entrée de pilotage (26) et qui comporte une ligne de transfert de données conduisant les sorties de pilotage (24) vers les entrées de pilotage (26) des canaux de mesure (2) ainsi qu'une sortie de données (20) vers un système de gestion de batterie, étant prévu que, d'une part les canaux de mesure (2) et d'autre part le branchement de pilotage et de traitement (4) sont alimentée par une source de courant (6) qui de son côté est alimenté par la batterie (12).

**2.** Module de mesure à batterie selon la revendication 1, dans lequel le système de pilotage et de traitement (4) est prévu avec une entrée de données (28) à laquelle peut être connectée une ligne de transfert de données (22)

**3.** Module de mesure à batterie selon la revendication 1, dans lequel la source de courant (6) peut être déconnectée.

**4.** Module de mesure à batterie selon la revendication 1, dans lequel comme système de pilotage et de traitement (4) est prévu un microcontrôleur.

**5.** Module de mesure à batterie selon la revendication 1, dans lequel, en tant que chaque canal de mesure 2 est prévue une portion analogique modifiée d'un convertisseur A/D selon le procédé dit à double-pente (« Dual-Slope »).

**6.** Module de mesure à batterie selon la revendication 1, dans lequel est prévue comme ligne de transfert de données (22) un guide d'ondes lumineuses.

**7.** Module de mesure à batterie selon la revendication 5, dans lequel la portion analogique modifiée comprend un intégrateur (38), un comparateur (40), un commutateur (42), une source de tension de référence (44) et un branchement en série (46) de deux résistances (R1, R2), dans lequel le branchement en série (46) est connecté du côté entrée avec l'entrée (8) du canal de mesure (2) et du côté sortie avec l'entrée inversée de l'intégrateur (38), dont la sortie est reliée avec l'entrée inversée du comparateur (40), dans lequel le pôle positif de la source de tension de référence (44) est connecté avec les entrées non inversées de l'intégrateur (38) et du comparateur (40) et du côté de son pôle négatif avec le potentiel de référence du module de mesure à batterie (48) et dans lequel le branchement (42) entre une liaison intermédiaire (48) du branchement en série (46) et le potentiel de référence du module de mesure à batterie sont branchés et dont le système d'actionnement est relié avec l'entrée de pilotage (26) du canal de mesure (2).

8. Module de mesure à batterie selon la revendication 7, dans lequel est prévu comme comparateur (40) un comparateur à sortie collectrice ouverte.

9. Module de mesure à batterie selon la revendication 6, dans lequel est prévue comme source de tension de référence (44) une source de tension comportant une valeur de tension de référence qui est plus petite que la valeur de tension de blocage à mesurer.

FIG 1

FIG 2

FIG 3